# EUROPEAN PATENT APPLICATION

(11) **EP 4 804 166 A1**
(43) Date of publication of application: **09.09.2026**
(21) Application number: 26160232.0
(22) Date of filing: 24.02.2026
(51) Int. Cl.: G09G 3/00

(54) **DISPLAY DEVICE AND ELECTRONIC DEVICE**

(30) Priority: 04.03.2025 KR 20250027750; 10.04.2025 KR 20250046614
(71) Applicant: Samsung Display Co., Ltd., Yongin-si, Gyeonggi-do (KR)
(72) Inventor: Bae, Yeonji, Yongin-si, Gyeonggi-Do (KR); Jung, Haegoo, Yongin-si, Gyeonggi-Do (KR)
(74) Representative: Gulde & Partner

(57) **Abstract**

A display device includes a display panel including a display region including a plurality of pixels disposed in the display region and a non-display region surrounding the display region, a plurality of display pads disposed in a pad region of the non-display region, a plurality of signal lines connected to the plurality of pixels, a data driver electrically connected to the plurality of signal lines, and a test unit disposed to be adjacent to the data driver. The test unit includes a plurality of test pads spaced apart from the plurality of display pads in a first direction, a plurality of connecting lines which connects the plurality of test pads to the plurality of signal lines, and a switching transistor connected to the plurality of connecting lines.

## Description

This application claims priority to Korean Patent Application No. 10-2025-0027750, filed on March 04, 2025, and Korean Patent Application No. 10-2025-0046614, filed on April 10, 2025.

### BACKGROUND

### (1) Field

Embodiments of the present disclosure described herein relate to a display device and an electronic device, and more particularly, relates to a display device and an electronic device improved in reliability.

### (2) Description of the Related Art

A display device, such as a television, a monitor, a smartphone, and a table, to provide an image to a user includes a display panel to display an image. Various display panels, such as a liquid crystal display panel, an organic light emitting display panel, an electro-wetting display panel, or an electrophoretic display panel, have been developed.

In a display device, the display panel may be bonded to an electronic part such as a flexible circuit board, and electrically connected to the electronic part.

### SUMMARY

Embodiments of the present disclosure provide a display device and an electronic device, which are improved in reliability by effectively preventing the corrosion of the test pad through a switching transistor.

According to an embodiment of the present disclosure, a display device includes a display panel including a display region including a plurality of pixels disposed in the display region and a non-display region surrounding the display region, a plurality of display pads disposed in a pad region of the non-display region, a plurality of signal lines connected to the plurality of pixels, a data driver electrically connected to the plurality of signal lines, and a test unit disposed to be adjacent to the data driver. In such an embodiment, the test unit includes a plurality of test pads spaced apart from the plurality of display pads in a first direction, a plurality of connecting lines extending in a second direction crossing the first direction, where the plurality of connecting lines connects the plurality of test pads to the plurality of signal lines, and a plurality of switching transistors electrically connected to the plurality of test pads, respectively, and to the plurality of signal lines, respectively.

According to an embodiment of the present disclosure, a display device includes a display panel including a display region including a plurality of pixels disposed in the display region and a non-display region surrounding the display region, a plurality of display pads disposed in a pad region of the non-display region, a plurality of signal lines connected to the plurality of pixels, and a test unit disposed to be adjacent to the plurality of display pads. In such an embodiment, the test unit includes a plurality of test pads spaced apart from the plurality of display pads in a first direction, a plurality of connecting lines which connects the plurality of test pads to the plurality of signal lines, respectively, and a plurality of switching transistors which is turned on in a first mode of the display panel, and turned off in a second mode different from the first mode of the display panel. In this way, in the second mode, no potential difference is generated across the test pads and as a result, the test pads are protected from potential difference corrosion.

According to an embodiment of the present disclosure, an electronic device includes a display device which displays an image, and a processor which provides image data to the display device. In such an embodiment, the display device includes a display panel including a display region including a plurality of pixels disposed in the display region and a non-display region surrounding the display region, a plurality of display pads disposed in a pad region of the non-display region, a plurality of signal lines connected to the plurality of pixels, a data driver electrically connected to the plurality of signal lines, and a test unit disposed to be adjacent to the data driver. In such an embodiment, the test unit includes a plurality of test pads spaced apart from the plurality of display pads in a first direction, a plurality of connecting lines which connects the plurality of test pads to the plurality of signal lines, respectively, and a plurality of switching transistors electrically connected to the plurality of test pads, respectively, and to the plurality of signal lines, respectively.

### BRIEF DESCRIPTION OF THE DRAWINGS

The above and other features of embodiments of the present disclosure will become apparent by describing in detail embodiments thereof with reference to the accompanying drawings, in which:
FIG. 1 is a block diagram of an electronic device according to an embodiment of the present disclosure;
FIG. 2 illustrates schematic views of various electronic devices according to an embodiment of the present disclosure;
FIG. 3 is an assembled perspective view of an electronic device, according to an embodiment of the present disclosure;
FIG. 4 is an exploded perspective view of an electronic device according to an embodiment of the present disclosure;
FIG. 5 is a cross-sectional view of a display module according to an embodiment of the present disclosure;
FIG. 6 is a plain view of a display panel according to an embodiment of the present disclosure;
FIG. 7 is a plan view of an input sensing unit according to an embodiment of the present disclosure;
FIG. 8 is a cross-sectional view of a display module according to an embodiment of the present disclosure;
FIG. 9 is a perspective view of an electronic device according to an embodiment of the present disclosure;
FIG. 10 and 11 are views to explain the driving of test pads according to an embodiment of the present disclosure;
FIGS. 12A and 12B are enlarged views of a portion of the display panel according to an embodiment of the present disclosure; and
FIGS. 13A and 13B are views to explain the driving of test pads according to an embodiment of the present disclosure.

### DETAILED DESCRIPTION

The invention now will be described more fully hereinafter with reference to the accompanying drawings, in which various embodiments are shown. This invention may, however, be embodied in many different forms, and should not be construed as limited to the embodiments set forth herein. Rather, these embodiments are provided so that this disclosure will be thorough and complete, and will fully convey the scope of the invention to those skilled in the art.

It will be understood that when an element is referred to as being "on" another element, it can be directly on the other element or intervening elements may be present therebetween. In contrast, when an element is referred to as being "directly on" another element, there are no intervening elements present. In the disclosure, the expression that a first component (or region, layer, or part) is "connected to", or "coupled to" a second component refers to that the first component is directly connected to, or coupled to the second component or refers to that a third component is interposed therebetween.

The same reference numeral will be assigned to the same component. In addition, in drawings, thicknesses, proportions, and dimensions of components may be exaggerated to describe the technical features effectively.

It will be understood that, although the terms "first," "second," "third" etc. may be used herein to describe various elements, components, regions, layers and/or sections, these elements, components, regions, layers and/or sections should not be limited by these terms. These terms are only used to distinguish one element, component, region, layer or section from another element, component, region, layer or section. Thus, "a first element," "component," "region," "layer" or "section" discussed below could be termed a second element, component, region, layer or section without departing from the teachings herein.

Furthermore, relative terms, such as "lower" or "bottom" and "upper" or "top," may be used herein to describe one element's relationship to another element as illustrated in the Figures. It will be understood that relative terms are intended to encompass different orientations of the device in addition to the orientation depicted in the Figures. For example, if the device in one of the figures is turned over, elements described as being on the "lower" side of other elements would then be oriented on "upper" sides of the other elements. The term "lower," can therefore, encompasses both an orientation of "lower" and "upper," depending on the particular orientation of the figure. Similarly, if the device in one of the figures is turned over, elements described as "below" or "beneath" other elements would then be oriented "above" the other elements. The terms "below" or "beneath" can, therefore, encompass both an orientation of above and below.

The terminology used herein is for the purpose of describing particular embodiments only and is not intended to be limiting. As used herein, "a", "an," "the," and "at least one" do not denote a limitation of quantity, and are intended to include both the singular and plural, unless the context clearly indicates otherwise. Thus, reference to "an" element in a claim followed by reference to "the" element is inclusive of one element and a plurality of the elements. For example, "an element" has the same meaning as "at least one element," unless the context clearly indicates otherwise. "At least one" is not to be construed as limiting "a" or "an." "Or" means "and/or." As used herein, the term "and/or" includes any and all combinations of one or more of the associated listed items. It will be further understood that the terms "comprises" and/or "comprising," or "includes" and/or "including" when used in this specification, specify the presence of stated features, regions, integers, steps, operations, elements, and/or components, but do not preclude the presence or addition of one or more other features, regions, integers, steps, operations, elements, components, and/or groups thereof.

Unless defined otherwise, all terms (including technical terms and scientific terms) used in the specification have the same meaning as commonly understood by one skilled in the art to which the present disclosure belongs. Furthermore, terms such as terms defined in the dictionaries commonly used should be interpreted as having a meaning consistent with the meaning in the context of the related technology, and should not be interpreted in ideal or overly formal meanings unless explicitly defined herein.

Embodiments are described herein with reference to cross section illustrations that are schematic illustrations of idealized embodiments. As such, variations from the shapes of the illustrations as a result, for example, of manufacturing techniques and/or tolerances, are to be expected. Thus, embodiments described herein should not be construed as limited to the particular shapes of regions as illustrated herein but are to include deviations in shapes that result, for example, from manufacturing. For example, a region illustrated or described as flat may, typically, have rough and/or nonlinear features. Moreover, sharp angles that are illustrated may be rounded. Thus, the regions illustrated in the figures are schematic in nature and their shapes are not intended to illustrate the precise shape of a region and are not intended to limit the scope of the present claims.

Hereinafter, embodiments of the disclosure will be described with reference to accompanying drawings.

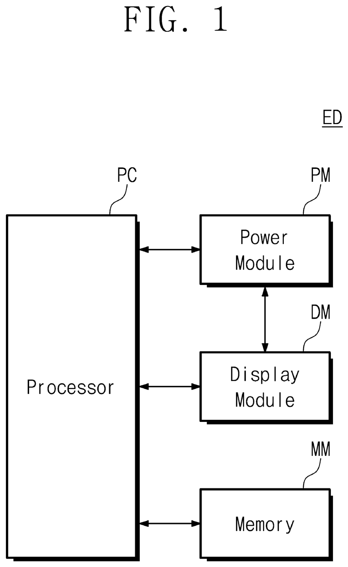

FIG. 1 is a block diagram of an electronic device according to an embodiment of the present disclosure.

Referring to FIG. 1, an electronic device ED according to an embodiment of the present disclosure may include a display module DM, a processor PC, a memory MM, and a power module PM.

The processor PC may include at least one selected from a central processing unit (CPU), an application processor (AP), a graphic processing unit (GPU), a communication processor (CP), an image signal processor (ISP), or a controller.

The memory MM may store data information used for the operation of the processor PC or the display module DM. When the processor PC runs the application stored in the memory MM, an image data signal and/or an input control signal may be transmitted to the display module DM, and the display module DM may process the transmitted signal and output the image information through the display screen.

The power module PM may include a power supply module, such as a power adaptor or a battery device, and a power converting module to convert the power supplied from the power supply module into power used for the operation of an electronic device ED.

At least one of components of the electronic device ED described above may be included in a display device according to embodiments to be described below. In addition, some of individual modules functionally included in one module may be included in the display device, and others of the individual modules may be provided separately from the display device. In an embodiment, for example, the display device may include the display module DM, and the processor PC, the memory MM, and the power module PM may be provided in the form of another device in the electronic device ED instead of the display device.

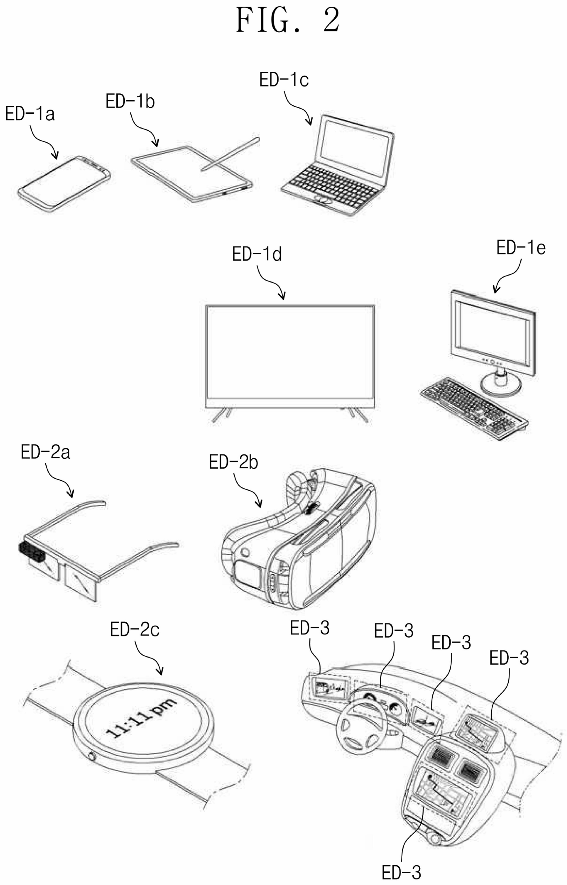

FIG. 2 illustrates schematic views of various electronic devices according to an embodiment of the present disclosure.

Referring to FIG. 2, various electronic devices, to which the display module according to an embodiment of the present disclosure is applied, may be a wearable electronic device such as smart glasses ED_2a, a head mounted display ED_2b, and a smart watch ED_2c, and a vehicle electronic device ED-3, such as a center information display (CID), which is disposed in an instrument panel, a centerfecia, and a dashboard of a vehicle, or a room mirror display, as well as an electronic device for image display, such as a smartphone ED_1a, a tablet personal computer (PC) ED_1b, a laptop computer ED_1c, a television ED_1d and a desk monitor ED_1e.

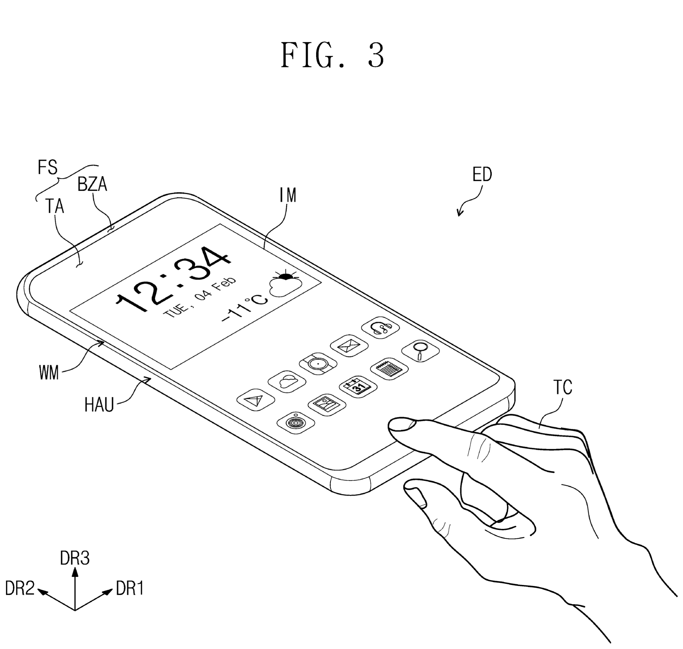

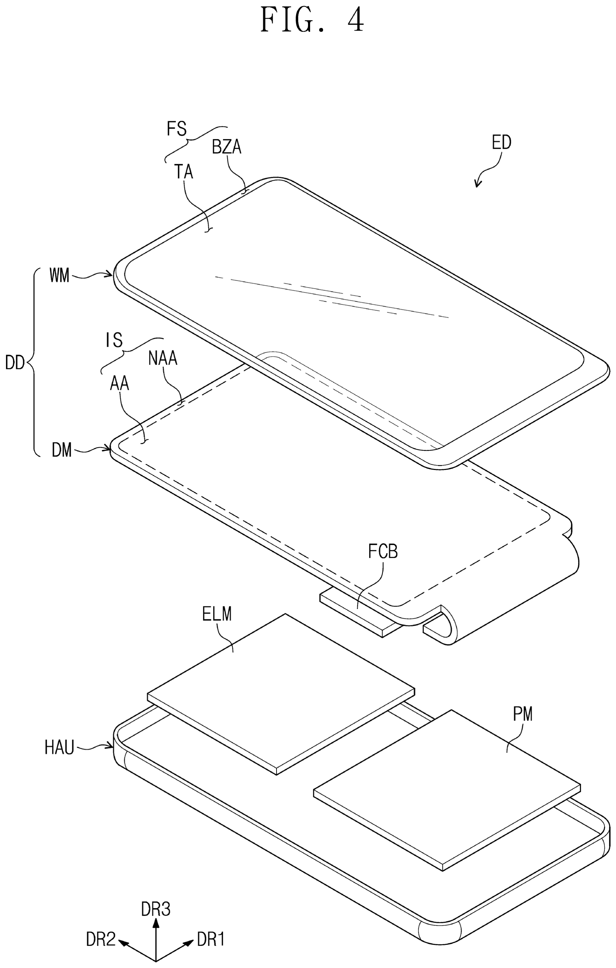

FIG. 3 is an assembled perspective view of an electronic device according to an embodiment of the present disclosure. FIG. 4 is an exploded perspective view of an electronic device according to an embodiment of the present disclosure.

Referring to FIGS. 3 and 4, an embodiment of the electronic device ED may be a device activated in response to an electrical signal to display an image IM, and to sense an external input TC. In an embodiment, for example, the electronic device ED may include a device such as a television, a monitor, an outdoor advertisement board, a personal computer, a laptop computer, a personal digital assistant (PDA), a vehicle dashboard, a center fascia, a navigation device, a room mirror display, a game console, a smartphone, a tablet, a smartwatch, smart glasses, a head-mounted display (HMD), and a camera. However, embodiments of the electronic device ED described above are provided only for the illustrative purpose, and the electronic device ED is not limited to any one embodiment unless departing from the present disclosure. According to an embodiment, a cellular phone is illustrated as an example of the electronic device ED.

The electronic device ED is in the shape of a rectangle having a shorter side extending in a first direction DR1 and a longer side extending in a second direction DR2 crossing the first direction DR1, when viewed in a plan view (or when viewed in a third direction DR3). However, an embodiment is not limited thereto, and the electronic device ED may have various shapes, such as a circle shape or a polygon shape, when viewed in a plan view.

According to an embodiment, the third direction DR3 may be defined as a direction perpendicular to a plan defined by the first direction DR1 and the second direction DR2. The third direction DR3 may be a thickness direction of the electronic device ED. A front surface (or top surface) and a rear surface (bottom surface) of each of members constituting the electronic device ED are opposite to each other in the third direction DR3, and a normal direction to the front surface and the rear surface may substantially parallel to the third direction DR3. The distance between the front surface and the rear surface defined in the third direction DR3 may correspond to the thickness of the member.

In the present disclosure, the wording "when viewed in a plan view" may refer to the state when viewed in the third direction DR3. In the present disclosure, the wording "when viewed in a cross-sectional view" may refer to the state when viewed in the first direction DR1 or the second direction DR2. Herein, directions indicated by the first direction DR1, the second direction DR2, and the third direction DR3 may be relative concepts and may be changed to different directions.

The electronic device ED may be rigid or flexible. The "flexible" characteristic refers to a bendable characteristic, and the flexible structure may include all structure ranging from a fully folded structure to a structure bent by a level of several nanometers. In an embodiment, for example, the flexible electronic device ED may include a curved electronic device, a rollable electronic device, or a foldable electronic device.

The electronic device ED may display an image IM on a display surface FS parallel to each of the first direction DR1 and the second direction DR2. The image IM may include a still image as well as a video (or a moving picture). FIG. 3 illustrates a clock and icons as examples of the image IM.

The display surface FS of the electronic device ED may include only the plane, OR may include curved surfaces bent from at least two or more sides of the plane. The front surface FS may correspond to the front surface of the electronic device ED and correspond to a front surface of a window WM. Hereinafter, the front surface FS of the electronic device ED and the front surface FS of the window WM may be assigned with the same reference numerals.

According to an embodiment, the electronic device ED may sense an external input TC applied from the outside. The external input TC may include various types of inputs such as force, pressure, a temperature, or light. According to an embodiment, the external input TC may be illustrated in the form of an input made by a user hand, which is applied to the front surface of the electronic device ED. However, such an embodiment is provided only for the illustrative purpose. The external input TC may include an input made by a pen or an input, such as hovering, approaching the electronic device ED.

The electronic device ED may sense a user input through the display surface FS defined on the front surface, and may react with the sensed input signal. However, a region, which senses the external input TC, of the electronic device ED is not limited to the front surface of the electronic device ED, and may be varied depending on the design of the electronic device ED. In an embodiment, for example, the electronic device ED may sense a user input applied to a side surface or a rear surface of the electronic device ED.

The electronic device ED may include a display device DD, an electronic module ELM, the power module PM, and a housing HAU. The electronic device DD includes the window WM and the display module DM. The window WM is coupled to the housing HAU to form an outer appearance of the electronic device ED.

The window WM may be disposed on the display module DM. The window WM may cover a front surface IS of the display module DM to protect the display module DM from an external shock and scratches. The window WM may be coupled to the display module DM through an adhesive layer.

The window WM may include an optically transparent insulating material. In an embodiment, for example, the window WM may include a base film including or formed of glass or synthetic resin. The window WM may have a single-layer structure or a multi-layer structure. In an embodiment, for example, the window WM in the multi-layer structure may include a plurality of synthetic resin films coupled to each other by an adhesive agent, or may include a glass film and a synthetic resin film coupled to each other by the adhesive agent. The window WM may include a functional layer, such as an anti-fingerprint layer, a phase control layer, or a hard coating layer disposed on a substrate optically transparent.

The front surface FS of the window WM may correspond to the front surface FS of the electronic device ED. The front surface FS of the window WM may include a transmissive region TA and a bezel region BZA.

The transmissive region TA may be an optically transparent region. The transmissive region TA may transmit the image IM provided by the display module DM. According to an embodiment, although the transmissive region TA is in a rectangular shape as shown in FIG. 4, the present disclosure is not limited thereto. The transmissive region TA may have various shapes.

The bezel region BZA may have a light transmittance lower than a light transmittance of the transmissive region TA. The bezel region BZA may correspond to a region printed with a material having a specific color. The bezel region BZA may prevent a light from being transmitted to prevent a component, which overlaps the bezel region BZA, of the display module DM from being viewed from the outside.

The bezel region BZA may be adjacent to the transmissive region TA. The shape of the transmissive region TA may be substantially defined by the bezel region BZA. In an embodiment, for example, the bezel region BZA may be disposed outside the transmissive region TA to surround the transmissive region TA in a plan view. However, such an embodiment is provided only for the illustrative purpose. In an embodiment, the bezel region BZA may be adjacent to only one side of the transmissive region TA, or may be disposed on a side surface of the electronic device ED, instead of the front surface of the electronic device ED. In an embodiment, the bezel region BZA may be omitted.

The display module DM may be interposed between the window WM and the housing HAU. The display module DM may display the image IM and may sense the external input TC. The image IM may be displayed on the front surface IS of the display module DM. The front surface IS of the display module DM may include an active region AA and a peripheral region NAA.

The active region AA may be activated in response to an electrical signal. In an embodiment, for example, the active region AA may be a region for displaying the image IM while sensing the external input TC. The active region AA may overlap at least a portion of the transmissive region TA. Accordingly, the user may view the image IM through the transmissive region TA or provide the external input TC through the transmissive region TA. However, such an embodiment is provided only for the illustrative purpose. In an embodiment, for example, in the active region AA, the region for displaying the image IM may be separated from the region for sensing the external input TC. However, the present disclosure is not limited to any one embodiment.

The peripheral region NAA may be adjacent to the active region AA. In an embodiment, for example, the peripheral region NAA may surround the active region AA. The peripheral region NAA may include a driving circuit or a driving wiring disposed to drive the active region AA. The peripheral region NAA may overlap at least a portion of the bezel region BZA, and components disposed in the peripheral region NAA may be prevented from being visually viewed from the outside by the bezel region BZA.

The display module DM may include a display panel DP and an input sensing unit ISP. The display panel DP may display the image IM, and the input sensing unit ISP may sense the external input TC. The details thereof will be described later.

A portion of the display module DM may be bent about a bending axis extending in the first direction DR1. In other words, the portion of the display module DM may be bent toward a rear surface, which corresponds to the active region AA, of the display module DM. A flexible circuit board (or a circuit board) FCB may be connected to the bent portion of the display module DM. Accordingly, the flexible circuit board FCB may overlap the display module DM when viewed in a plan view.

The flexible circuit board FCB may be electrically connected to the display module DM, at a side of the display module DM. The flexible circuit board FCB may generate an electrical signal provided to the display module DM, or receive a signal generated from the display module DM to calculate a result value including a position or intensity information of the sensed external input TC.

The electronic module ELM and the power module PM may be disposed under the display module DM. The electronic module ELM and the power module PM may be electrically connected through a separate circuit board.

The power module PM may supply power used for operating the electronic device ED. In an embodiment, for example, the power module PM may include a typical battery module.

The electronic module ELM may include various functional modules to operate the electronic device ED. In an embodiment, for example, the electronic module ELM may include a control module, a wireless communication module, an image input module, a sound input module, a sound output module, a memory, an optical module, and an external interface module. The electronic module ELM may include a main circuit board, and the modules of the electronic module ELM may be mounted on the main circuit board, or may be electrically connected to the main circuit board through a separate circuit board.

The control module among the electronic module ELM may control an overall operation of the electronic device ED. In an embodiment, for example, the control module may activate or deactivate the display module DM to match with a user input. The control module may include at least one microprocessor. The optical module among the electronic module ELM may include a camera module, a proximity sensor, a biometric sensor to recognize a part of a user body (for example, a fingerprint, an iris, or a face), or a lamp to output light.

The housing HAU may be coupled to the window WM to provide an internal space which receives the display module DM, the electronic module ELM, the power module PM, and the flexible circuit board FCB. The housing HAU may include a material having higher rigidity. In an embodiment, for example, the housing HAU may include glass, plastic, or metal or may include a plurality of frames and/or plates which includes the combination thereof. The housing HAU may protect components of the electronic device ED received in the housing HAU by absorbing impact applied from the outside or preventing foreign materials/water from being infiltrated into the electronic device ED from the outside.

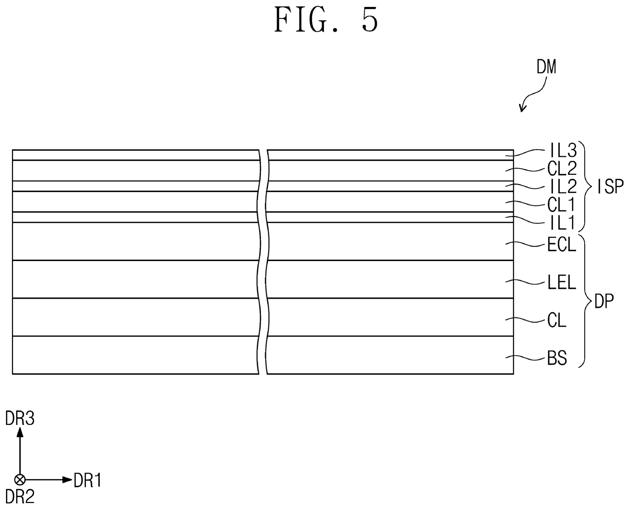

FIG. 5 is a cross-sectional view of a display module, according to an embodiment of the present disclosure.

Referring to FIG. 5, an embodiment of the display module DM may include the display panel DP and the input sensing unit ISP. The input sensing unit ISP may be directly disposed on the display panel DP. In an embodiment, for example, the input sensing unit ISP may be directly disposed on the display panel DP. According to an embodiment, the wording "the input sensing unit ISP is directly disposed on the display panel DP" means that the input sensing unit ISP is formed on the display panel DP through a subsequent process, such that the input sensing unit ISP and the display panel DP are coupled to each other without a separate adhesive layer. In other words, components of the input sensing unit ISP may be formed on a base surface provided by the display panel DP.

The display panel DP may display the image in response to the electrical signal. The display panel DP according to an embodiment may be an emissive-type display panel, but the present disclosure is not particularly limited thereto. In an embodiment, for example, the display panel DP may be an organic light emitting display panel, an inorganic light emitting display panel, or a quantum dot light emitting display panel. A light emitting layer of the organic light emitting display panel may include an organic light emitting material, and a light emitting layer of the inorganic light emitting display panel may include an inorganic light emitting material. A light emitting layer of the quantum dot light emitting display panel may include a quantum dot, or a quantum rod. Hereinafter, for convenience of description, embodiments where the display panel DP is the organic light emitting display panel will be mainly described as an example.

In an embodiment, the display panel DP may include a base substrate BS, a circuit element layer CL, a light emitting element layer LEL, and an encapsulating layer ECL, which are sequentially stacked in the third direction DR3.

The base substrate BS may be a rigid substrate, or a flexible substrate allowing bending, folding, or rolling. In an embodiment, for example, the base substrate BS may be a glass substrate, a metal substrate, or a polymer substrate. The base substrate BS may provide a base surface for disposing the circuit element layer CL.

The base substrate BS may be an inorganic layer, an organic layer, or a composite material layer. The base substrate BS may have a single-layer structure or a multi-layer structure. In an embodiment, for example, the base substrate BS in the multi-layer structure may include synthetic resin layers and a multi-layer or single-layer inorganic layer interposed between the synthetic resin layers. Each of the synthetic resin layers may include an acrylic resin, a methacrylic resin, polyisoprene, a vinyl resin, an epoxy resin, a urethane resin, a cellulose resin, a siloxane resin, a polyamide resin, or a perylene resin, but the material of the synthetic resin layers is not limited thereto.

The circuit element layer CL may be disposed on the base substrate BS. The circuit layer CL may include at least one insulating layer, a semiconductor pattern, and a conductive pattern. The insulating layer, the semiconductor pattern, and the conductive pattern included in the circuit layer CL may form or collectively define driving elements, such as transistors, signal lines, and pads, in the circuit layer CL.

The light emitting element layer LEL may be disposed on the circuit element layer CL. The light emitting element layer LEL may include a plurality of light emitting elements, each of which may emit light. In an embodiment, for example, the light emitting elements may include an organic light emitting element, an inorganic light emitting element, a micro-light emitting diode (LED), or a nano-LED. The light emitting elements in the light emitting element layer EDL may be electrically connected to the driving elements of the circuit layer CL to emit a light in response to an electrical signal provided by the driving elements.

The encapsulating layer ECL may be disposed on the light emitting element layer LEL, and may seal the light emitting elements. The encapsulating layer ECL may include at least one thin film to improve an optical efficiency of the light emitting element layer LEL or to protect the light emitting element layer LEL. In an embodiment, for example, the encapsulating layer ECL may include at least one selected from an inorganic film and an organic film. The inorganic film of the encapsulating layer ECL may protect the light emitting elements from moisture and oxygen. The organic film of the encapsulating layer ECL may protect the light emitting elements from foreign substances such as dust particles.

The input sensing unit ISP may sense an external input, and may provide an input signal including information on the external input, such that the display panel DP displays an image corresponding to the external input. The input sensing unit ISP may be driven by various manners such as a capacitive manner, a resistive film manner, an infrared manner, an acoustic manner, or a pressure manner, and a driving manner of the input sensing unit ISP is not limited as long as the input sensing unit ISP senses the external input. According to an embodiment, the input sensing unit ISP may be in the form of an input sensing panel driven through a capacitive manner.

The input sensing unit ISP may include a base layer IL1, a first sensing conductive layer CL1, a first sensing insulating layer IL2, a second sensing conductive layer CL2, and a second sensing insulating layer IL3, which are sequentially stacked in the third direction DR3. The base layer IL1 of the input sensing unit ISP may make contact with the encapsulating layer ECL. However, the present disclosure is not limited thereto, and at least one of the base layer IL1 or the second sensing insulating layer IL3 may be omitted.

Each of the first sensing conductive layer CL1 and the second sensing conductive layer CL2 may have a single-layer structure or a multi-layer structure. The conductive layer in the multi-layer structure may include at least two of transparent conductive layers and metal layers. The conductive layer in the multi-layer structure may include metal layers including mutually different metals. The transparent conductive layer may include at least one selected from indium tin oxide (ITO), indium zinc oxide (IZO), zinc oxide (ZnO), indium tin zinc oxide (ITZO), PEDOT, metal nanowires, and graphene. A metal layer may include at least one selected from molybdenum, silver, titanium, copper, aluminum, and alloys thereof. In an embodiment, for example, each of the first sensing conductive layer CL1 and the second sensing conductive layer CL2 may have a two-layer structure, such as a two-layer structure of an ITO/copper, but the present disclosure is not limited. In an embodiment, for example, each of the first sensing conductive layer CL1 and the second sensing conductive layer CL2 may have a three-layer structure of titanium/aluminum/titanium.

Each of the first sensing conductive layer CL1 and the second sensing conductive layer CL2 may include sensing conductive patterns. The sensing conductive patterns of the first sensing conductive layer CL1 and the second sensing conductive layer CL2 may form or define sensing electrodes and sensing lines connected thereto, which constitute the input sensing unit ISP.

Each of the base layer IL1, the first sensing insulating layer IL2, and the second sensing insulating layer IL3 may include at least one selected from an inorganic film and an organic film. In an embodiment, for example, the inorganic film may include at least one selected from aluminum oxide, titanium oxide, silicon oxide, silicon oxynitride, zirconium oxide, or hafnium oxide, and the organic film may include at least one selected from acrylic resin, methacrylic resin, polyisoprene, vinyl resin, epoxy resin, urethane resin, cellulose resin, siloxane resin, polyimide resin, polyamide resin, or perylene resin. However, materials of the inorganic film and the organic film are not limited to the above examples. According to an embodiment, the base layer IL1 may include an inorganic film, and the first sensing insulating layer IL2 and the second sensing insulating layer IL3 may include an organic film. However, the present disclosure is not limited thereto.

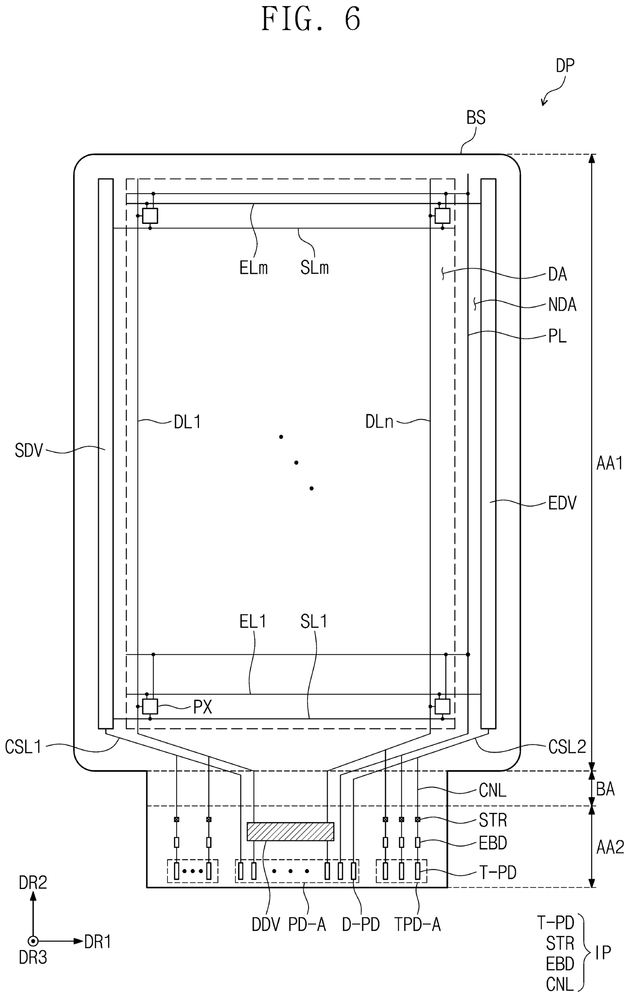

FIG. 6 is a plan view of a display panel according to an embodiment of the present disclosure.

Referring to FIG. 6, an embodiment of the display panel DP may include a base substrate BS, a plurality of pixels PX, signal lines SL1 to SLm, DL1 to DLn, EL1 to ELm, CSL1, CSL2, and PL electrically connected to the pixels PX, a scan driver SDV, an emission driver EDV, a data driver DDV, and a plurality of display pads D-PD.

The base substrate BS may provide a base surface for disposing electrical elements and lines of the display panel DP. The base substrate BS may include a first base region AA1, a bending region BA, and a second base region AA2, which are divided in the second direction DR2. A bending region BA may extend from the first base region AA1 in the second direction DR2. The second base region AA2 may extend from the bending region BA in the second direction DR2. Accordingly, the first base region AA1 and the second base region AA2 may be spaced apart from each other while interposing the bending region BA between the first base region AA1 and the second base region AA2.

The first base region AA1 may include the display region DA. The display region DA may be a region for disposing light emitting elements of the pixels PX. Accordingly, the pixels PX may display an image through the display region DA. The display region DA may correspond to an active region AA of the display module DM (see FIG. 4), and may overlap the transmissive region TA of the window WM (see FIG. 4).

The remaining portion of the first base region AA1 other than the display region DA, the bending region BA, and the second base region AA2 may be defined as a non-display region NDA. The non-display region NDA may be adjacent to the display region DA, and may be a region in which an image is not illustrated. The non-display region NDA may surround the display region DA. The non-display region NDA may be provided therein with the scan driver SDV, the emission driver EDV, the data driver DDV to drive the pixels PX, and the display pads D-PD, which are electrically connected to the signal lines SL1 to SLm, DL1 to DLn, EL1 to ELm, CSL1, CSL2, and PL. The signal lines SL1 to SLm, DL1 to DLn, EL1 to ELm, CSL1, CSL2, and PL, which are electrically connected to the pixels PX, may be extended and disposed on the non-display region NDA.

The bending region BA may be bent about a bending axis extending in the first direction DR1. In other words, the bending region BA may be bent toward a rear surface of the display panel DP corresponding to the first base region AA1. The second base region AA2, which extends from one side of the bending region BA, may overlap the first base region AA1 when viewed in a plan view, as the bending region BA is bent. In other words, the second base region AA2 may be disposed on the rear surface, which corresponds to the first base region AA1, of the display panel DP.

The width of each of the bending region BA and the second base region AA2 in the first direction DR1 may be narrower than a width of the first base region AA1. As the bending region BA has a width smaller than the width the first base region AA1 in a direction parallel to the bending axis, the bending region BA may be easily bent. However, such an embodiment is illustrated only for the illustrative purpose. At least one of the widths of the bending region BA and the second base region AA2 in the first direction DR1 may be equal to the width of the first base region AA1. However, the present disclosure is not limited thereto.

The second base region AA2 may be a region positioned, in a flat form, under the first base region AA1, as the bending region BA is bent. The second base region AA2 may be a region for disposing signal lines, which extend toward a display pads D-PD through the bending region BA, among the signal lines SL1 to SLm, DL1 to DLn, EL1 to Elm, CSL1, CSL2, and PL, and the data driver DDV.

A region for disposing the display pads D-PD and a region for disposing test pads T-PD may be classified as a display pad region PD-A and a test pad region TPD-A, respectively. FIG. 6 illustrates an embodiment where the display pad region PD-A and the test pad region TPD-A are divided into each other in the first direction DR1. In an embodiment, for example, the test pad regions TPD-A may be provided adjacent to opposite sides of the second base region AA2 in the first direction DR1, and the display pad region PD-A may be provided at a central portion. However, the present disclosure is not limited thereto. The positions for disposing the display pads D-PD and the test pads T-PD may be variously changed. The defects of the pixels PX may be tested through the test pads T-PD. In this way, a reliable indicator for pixel defects is provided.

The display panel DP according to an embodiment of the present disclosure may include a test unit IP. The test unit IP may include test pads T-PD disposed in the test pad region TPD-A, an electrostatic discharge protecting diodes EBD, and a plurality of connecting lines CNL, and a plurality of switching transistors STR. The plurality of connecting lines CNL may be electrically connected to switching transistors STR, respectively. The switching transistors STR and the electrostatic discharge protecting diodes EBD may be electrically connected to the signal lines DL1 to DLn, CSL1, CSL2, and PL. The test unit IP may be disposed adjacent to the data driver DDV or adjacent to the plurality of display pads D-PD but the disclosure is not limited thereto.

The switching transistors STR and the electrostatic discharge protecting diodes EBD may be electrically connected to the test pads T-PD. In an embodiment, for example, the switching transistors STR and the electrostatic discharge protecting diodes EBD may be electrically connected to the test pads T-PD through the plurality of connecting lines CNL. The switching transistors STR and the electrostatic discharge protecting diodes EBD may be connected to first and second control lines CSL1 and CSL2, data lines DL1 to DLn, and a power line PL through the plurality of connecting lines CNL.

The electrostatic discharge protecting diodes EBD may prevent the test pads T-PD from being damaged by electrostatic discharge introduced from the outside. In an embodiment, for example, the electrostatic discharge protecting diodes EBD may be transient voltage suppressor (TVS) diodes. The electrostatic discharge protecting diodes EBD may become turned on when an external overvoltage is applied, such that a pulse current is dissipated in the electrostatic discharge protecting diodes EBD, thereby protecting the test pads T-PD from electrostatic discharge.

The switching transistors STR may control a current flowing into the electrostatic discharge protecting diodes EBD and the test pads T-PD. In an embodiment, for example, when the test pads T-PD applies the test signal to the pixels PX, the switching transistors STR may be turned on. When the test pads T-PD does not apply the test signal to the pixels PX, but signals (for example, a control signal, a data signal, and a power voltage) are applied to the pixels PX through the first and second control lines CSL1 and CSL2, the data lines DL1 to DLn, and the power line PL, the switching transistors STR may be turned off. The details thereof will be described later.

The flexible circuit board FCB (see FIG. 4) may be disposed on the second base region AA2 in which display pads D-PD are disposed, and may be electrically connected to the display pads D-PD. The flexible circuit board FCB (see FIG. 4) disposed adjacent to a lower portion of the second base region AA2 may be positioned on the rear surface of the display panel DP as the bending region BA is bent. As the second base region AA2 and the flexible circuit board FCB (see FIG. 4) are positioned under the first base region AA1, on the front surface of the electronic device ED (see FIG. 4), the bezel region of the electronic device ED (see FIG. 4) may be reduced.

Each of the pixels PX may include a pixel driving circuit, which includes transistors (for example, a driving transistor) and at last one capacitor, and a light emitting element electrically connected to the pixel driving circuit. Each of the pixels PX may generate a light in response to an electrical signal applied to the relevant pixel PX, and may display the image through the display region DA. According to an embodiment, some of the pixels PX may include transistors disposed in the non-display region NDA, but the present disclosure is not limited thereto. In this way, a larger area of the base substrate BS is exploited.

The scan driver SDV and the emission driver EDV may be disposed in the non-display region NDA corresponding to the first base region AA1. The data driver DDV may be disposed in the non-display region NDA corresponding to the second base region AA2. According to an embodiment, the data driver DDV may be provided in a form of an integrated circuit chip mounted within the non-display region NDA of the display panel DP. However, the present disclosure is not limited thereto, and the data driver DDV may be mounted on the flexible circuit board FCB (see FIG. 4).

The signal lines SL1 to SLm, DL1 to DLn, EL1 to ELm, CSL1, CSL2, and PL may include the scan lines SL1 to SLm, the data lines DL1 to DLn, the emission lines EL1 to Elm, the first and second control lines CSL1 and CSL2, and the power line PL. Here, "m" and "n" represents natural numbers greater than 1.

The data lines DL1 to DLn may be insulated from the scan lines SL1 to SLm and the emission lines EL1 to Elm while crossing the scan lines SL1 to SLm and the emission lines EL1 to ELm. In an embodiment, for example, the scan lines SL1 to SLm may extend in the first direction DR1 and may be electrically connected to the scan driver SDV. The data lines DL1 to DLn may extend in the second direction DR2 and may be electrically connected to the data driver DDV. The emission lines EL1 to ELm may extend in the first direction DR1 and may be electrically connected to the emission driver EDV.

The power line PL may include a portion extending in the first direction DR1 and a portion extending in the second direction DR2. The portion, which extends in the first direction DR1, of the power line PL and the portion, which extends in the second direction DR2, of the power line PL may be disposed on mutually different layers or integrally disposed in (or directly on) a same layer as each other. The portion, which extends in the first direction DR1, of the power line PL may be electrically connected to the pixels PX and to the portion extending in the second direction DR2. The portion, which extends in the second direction DR2, of the power line PL may be disposed in the non-display region NDA, and may be electrically connected to the display pads D-PD through the bending region BA, and the second base region AA2 from the first base region AA1. The power line PL may supply the power voltage to the pixels PX.

The first control line CSL1 may be electrically connected to the scan driver SDV and may extend toward a lower portion of the second base region AA2 through the bending region BA. The second control line CSL2 may be electrically connected to the emission driver EDV and may extend toward the lower portion of the second base region AA2 through the bending region BA.

The display pads D-PD may be disposed adjacent to the lower portion of the second base region AA2. The display pads D-PD may be disposed closer to a lower portion of the base substrate BS rather than the driver chip DDV, on the second base region AA2. The display pads D-PD may be spaced apart from each other in the first direction DR1. Each of the power line PL, the first control line CSL1, and the second control line CSL2 may each be electrically connected to a relevant display pad D-PD among the display pads D-PD. The data lines DL1 to DLn may each be electrically connected to the relevant display pad D-PD among the display pads D-PD through the data driver DDV.

The display pads D-PD may be electrically connected to the flexible circuit board FCB (see FIG. 4) through an adhesive layer, and electrical signals provided from the flexible circuit board FCB (see FIG. 4) may be transmitted to the display panel DP through the display pads D-PD. However, the connection manner between the display pads D-PD and the flexible circuit board FCB (see FIG. 4) is not limited thereto.

The scan driver SDV may generate scan signals in response to a scan control signal. The scan signals may be applied to pixels the PX through the scan lines SL1 to SLm. The data driver DDV may generate data voltages corresponding to the image signals in response to the data control signal. The data voltages may be applied to the pixels PX through the data lines DL1 to DLn. The emission driver EDV may generate emission signals in response to an emission control signal. The emission signals may be applied to the pixels PX through the emission lines EL1 to ELm.

The pixels PX may receive the data voltages in response to the scan signals. The pixels PX may generate an image by emitting light having a luminance corresponding to the data voltages in response to the emission signals. The time for emitting a light in the pixels PX may be controlled by the emission signals.

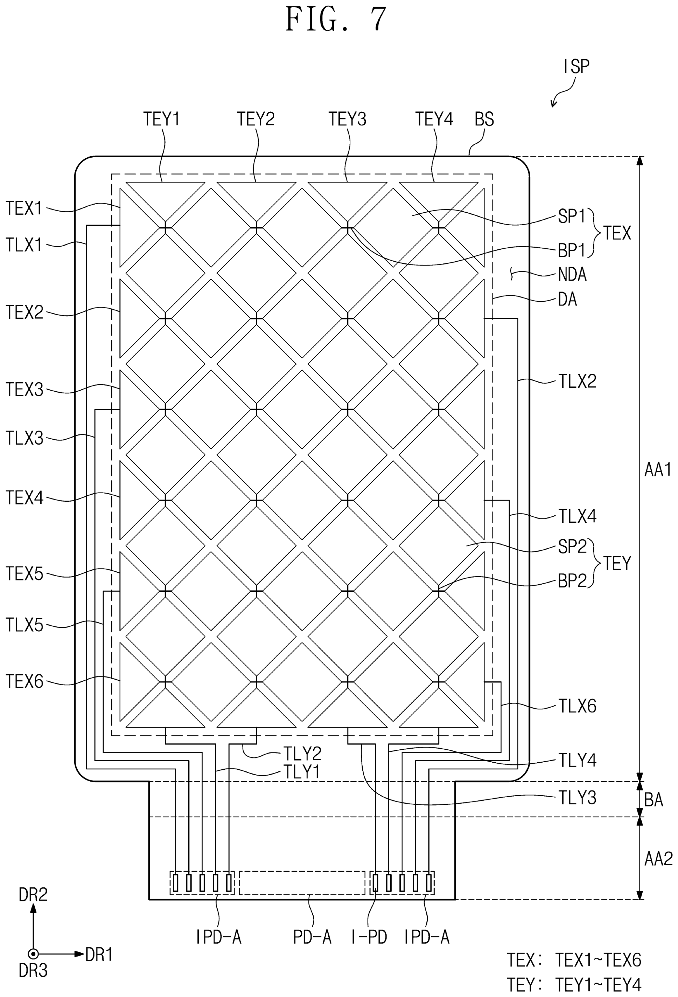

FIG. 7 is a plan view of an input sensing unit according to an embodiment of the present disclosure. FIG. 7 illustrates components of the input sensing unit ISP disposed on the base substrate BS described above for the convenience of explanation.

According to an embodiment of the present disclosure, the input sensing unit ISP may be driven in a mutual-cap type manner. Referring to FIG. 7, the input sensing unit ISP may include first sensing electrodes TEX (TEX1 to TEX6), second sensing electrodes TEY (TEY1 to TEY4), first sensing lines TLX1 to TLX6, second sensing lines TLY1 to TLY4, and sensing pads I-PD. However, the present disclosure is not limited thereto. In an embodiment, for example, the input sensing unit ISP may be driven in a self-cap type manner.

Each first sensing electrode TEX may extend in the first direction DR1, and the first sensing electrodes TEX may be arranged in the second direction DR2. FIG. 7 illustrates only six first sensing electrodes TEX1 to TEX6 for convenience of illustration. However, the number of the first sensing electrodes TEX included in the input sensing unit ISP is not limited thereto. One first sensing electrode TEX may include first sensing patterns SP1 arranged in the first direction DR1 and first connecting patterns BP1 to connect the first sensing patterns SP1 to each other.

Each second sensing electrode TEY may extend in the second direction DR2, and the second sensing electrodes TEY may be arranged in the first direction DR1. FIG. 7 illustrates only four second sensing electrodes TEY1 to TEY4 for convenience of illustration. However, the number of the second sensing electrodes TEY included in the input sensing unit ISP is not limited thereto. One second sensing electrode TEY may include second sensing patterns SP2 arranged in the second direction DR2 and second connecting patterns BP2 to connect the second sensing patterns SP2 to each other.

The first sensing electrodes TEX and the second sensing electrodes TEY may be electrically insulated from each other. The input sensing unit ISP may sense an external input through a change in capacitance between the first sensing electrodes TEX and the second sensing electrodes TEY. The first sensing electrodes TEX and the second sensing electrodes TEY may be disposed in a region corresponding to the display region DA of the base substrate BS. Accordingly, the electronic device ED (see FIG. 3) may sense an external input applied to the display region DA while displaying an image through the display region DA.

The first sensing lines TLX1 to TLX6 may be disposed in the non-display region NDA and may be electrically connected to the respective the first sensing electrodes TEX1 to TEX6, respectively. Some of the first sensing lines TLX1 to TLX6 may be disposed on a left side of the non-display region NDA, and remaining ones of the first sensing lines TLX1 to TLX6 may be disposed on a right side of the non-display region NDA. In an embodiment, for example, the first sensing lines TLX1, TLX3, and TLX5 connected to the first sensing electrodes TEX1, TEX3, and TEX5 arranged in odd-numbered rows may be connected to left sides of the first sensing electrodes TEX1, TEX3, and TEX5, respectively. The first sensing lines TLX2, TLX4, and TLX6 connected to the first sensing electrodes TEX2, TEX4, and TEX6 arranged in even-numbered rows may be connected to right sides of the first sensing electrodes TEX2, TEX4, and TEX6, respectively. However, the arrangement of the first sensing lines TLX1 to TLX6 is not limited thereto. In an embodiment, for example, all the first sensing lines TLX1 to TLX6 may be disposed at the left side of the non-display region NDA, or may be disposed at the right side of the non-display region NDA.

Each of the first sensing lines TLX1 to TLX6 may extend toward the second base region AA2 through the bending region BA from a first base region AA1. The first sensing lines TLX1 to TLX6 may be electrically connected to the sensing pads I-PD disposed on the second base region AA2.

The second sensing lines TLY1 to TLY4 may be disposed in the non-display region NDA and may be electrically connected to the second sensing electrodes TEY1 to TEY4, respectively. Some of the second sensing lines TLY1 to TLY4 may be disposed adjacent to theft side of the non-display region NDA, and the remaining ones of the second sensing lines TLY1 to TLY4 may be disposed adjacent to the right side of the non-display region NDA. In an embodiment, for example, the second sensing lines TLY1 and TLY2, which are electrically connected to the second sensing electrodes TEY1 and TEY2 disposed on the left side, among the second sensing electrodes TEY1 to TEY4 in the first direction DR1 may be disposed adjacent to the left side of the first base region AA1. The second sensing lines TLY3 and TLY4 electrically connected to the second sensing electrodes TEY3 and TEY4 disposed on the right side may be disposed adjacent to the right side of the first base region AA1. However, the arrangement of the second sensing lines TLY1 to TLY4 is not limited thereto.

Each of the second sensing lines TLY1 to TLY4 may extend toward the second base region AA2 through the bending region BA from the region adjacent to the lower portion of the first base region AA1. The second sensing lines TLY1 to TLY4 may be electrically connected to the sensing pads I-PD disposed on the second base region AA2.

Some of the sensing pads I-PD may be disposed in a region adjacent to the left side of the second base region AA2 in the first direction DR1, and the remaining ones of the sensing pads I-PD may be disposed in a region adjacent to the right side of the second base region AA2. In an embodiment, for example, the sensing pads I-PD may be divided into two groups spaced apart from each other while interposing the display pad region PD-A between the two groups. However, the arrangement of the sensing pads I-PD is not limited thereto.

The sensing pads I-PD may be disposed on a layer the same as the layer of display pads D-PD (see FIG. 6). The sensing pads I-PD may be disposed on a layer different from a layer for the first and second sensing lines TLX1 to TLX6 and TLY1 to TLY4, and may be connected through a contact hole. However, the present disclosure is not limited thereto, and the sensing pads I-PD may be disposed in (or directly on) a layer different from a layer for (or defining) the display pads D-PD (see FIG. 6). In an embodiment, for example, the sensing pads I-PD may be integrally formed with a layer for the first and second sensing lines TLX1 to TLX6 and TLY1 to TLY4 as a single unitary indivisible part.

The first and second sensing lines TLX1 to TLX6 and TLY1 to TLY4 may be disposed above components of a display panel DP (see FIG. 6) on a region corresponding to the non-display region NDA of a base substrate BS. Accordingly, the first and second sensing lines TLX1 to TLX6 and TLY1 to TLY4 may overlap components of the display panel DP (see FIG. 6) in the bending region BA and the second base region AA2.

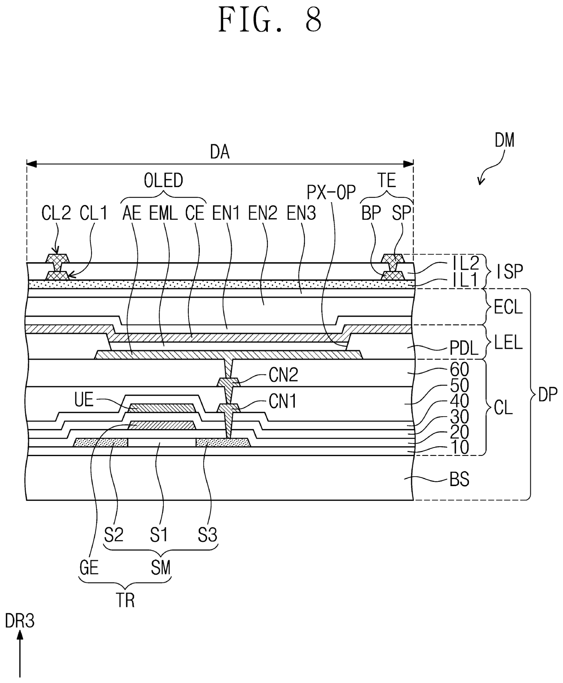

FIG. 8 is a cross-sectional view of a display module according to an embodiment of the present disclosure. FIG. 8 is a cross-sectional view of the pixel PX (see FIG. 6) disposed in the display region DA.

Referring to FIG. 8, an embodiment of the display module DM may include the display panel DP and the input sensing unit ISP disposed on the display panel DP. Any repetitive detailed description of the same or like components as those described above will be omitted to avoid redundancy.

In an embodiment, as described above with reference to FIG. 5, the display panel DP may include the base substrate BS, the circuit element layer CL, the light emitting element layer LEL, and the encapsulating layer ECL.

The base substrate BS may have an insulating property, and may provide a base surface to dispose the components of the display module DM. The base substrate BS may be flexible to allow bending. In an embodiment, as described above, the base substrate BS may include the first base region AA1 (see FIG. 6), the bending region BA (see FIG. 6), and the second base region AA2 (see FIG. 6), and the bending region BA of the base substrate BS may be bent with a specific curvature.

The circuit element layer CL may include insulating layers 10 to 60 disposed on the base substrate BS, a transistor TR of the pixel PX (see FIG. 6), an upper electrode UE, and connecting electrodes CN1 and CN2. The insulating layers 10 to 60 may include the first to sixth insulating layers 10 to 60 sequentially stacked in a thickness direction (or the third direction DR3) on the base substrate BS. However, embodiments of the insulating layers 10 to 60 included in the circuit element layer CL are not limited thereto, but may vary depending on the configuration or manufacturing process of the circuit element layer CL.

The first insulating layer 10 may be disposed on the base substrate BS. The first insulating layer 10 may be provided in the form of a barrier layer and/or buffer layer to prevent foreign substances from being introduced from the outside. The first insulating layer 10 may improve adhesion between the base substrate BS and a semiconductor pattern SM and/or conductive pattern of the circuit element layer CL. The first insulating layer 10 may include at least one of a silicon oxide layer or a silicon nitride layer. According to an embodiment, the first insulating layer 10 may include silicon oxide layers and silicon nitride layers which are alternately stacked.

The pixel PX (see FIG. 6) may be disposed on the base substrate BS. The pixel PX (see FIG. 6) may be disposed corresponding to (or to overlap) the display region DA. The pixel PX (see FIG. 6) may include the transistor TR and the light emitting element OLED.

The transistor TR may include the semiconductor pattern SM and a gate electrode GE. The semiconductor pattern SM may be disposed on the first insulating layer 10. The semiconductor pattern SM may include a channel S1, a source S2, and a drain S3. The semiconductor pattern SM may include a silicon semiconductor, and may include a single crystal silicon semiconductor, a polycrystalline silicon semiconductor, or an amorphous silicon semiconductor. The present disclosure is not limited thereto. The semiconductor pattern SM may include an oxide semiconductor. The semiconductor pattern SM according to an embodiment of the present disclosure may include various materials as long as the semiconductor pattern SM has semiconductor properties. However, the present disclosure is not limited to any one embodiment.

The semiconductor pattern SM may include a plurality of regions having different electrical properties depending on whether the semiconductor pattern SM is doped or reduced. In an embodiment, for example, the semiconductor pattern SM may include a region that is doped or reduced with metal oxide to have high conductivity. The region having high conductivity may function as an electrode of the transistor TR or a signal line. The region may correspond to the source S2 and the drain S3 of the transistor TR. The semiconductor pattern SM may include a region which is not doped to have lower conductivity. The region may correspond to the channel S1 (or active region) of the transistor TR.

The second insulating layer 20 may be disposed on the first insulating layer 10 to cover the semiconductor pattern SM. A gate electrode GE may be disposed on the second insulating layer 20. The second insulating layer 20 may be interposed between the semiconductor pattern SM and the gate electrode GE of the transistor TR. The gate electrode GE may overlap the channel S1 of the semiconductor pattern SM, when viewed in a plane view. The gate electrode GE may function as a mask in a process for doping the semiconductor pattern SM. The gate electrode GE may include molybdenum (Mo), a molybdenum-containing alloy, titanium (Ti), or a titanium-containing alloy having heat resistance, but the present disclosure is not limited thereto.

The structure of the transistor TR shown in FIG. 8 is merely an example, and in an embodiment, the source S2 or the drain S3 of the transistor TR may be electrodes formed independently from the semiconductor pattern SM. In such an embodiment, the source S2 and the drain S3 may make contact with the semiconductor pattern SM or may be connected to the semiconductor pattern SM through an insulating layer. In an embodiment, the gate electrode GE may be disposed under the semiconductor pattern SM. The transistor TR according to an embodiment of the present disclosure may be formed in various structures. However, the present disclosure is not limited to any one embodiment.

In an embodiment, the second insulating layer 20 and the third to sixth insulating layers 30 to 60 may include at least one selected from an inorganic layer or an organic layer. In an embodiment, for example, the inorganic layer may include at least one selected from aluminum oxide, titanium oxide, silicon oxide, silicon oxynitride, zirconium oxide, or hafnium oxide. The organic layer may include at least one selected from an acrylic resin, methacrylic resin, polyisoprene, vinyl resin, epoxy resin, urethane resin, cellulose resin, siloxane resin, polyamide resin, or perylene resin.

The third insulating layer 30 may be disposed on the second insulating layer 20 to cover the gate electrode GE. The upper electrode UE may be disposed on the third insulating layer 30. The upper electrode UE may overlap the gate electrode GE when viewed in a plan view, and the gate electrode GE and the upper electrode UE, which overlap each other, may form or collectively define a capacitor.

The fourth insulating layer 40 may be disposed on the third insulating layer 30 to cover the upper electrode UE. The connecting electrodes CN1 and CN2 may include the first connecting electrode CN1 and the second connecting electrode CN2. The first connecting electrode CN1 may be disposed on the fourth insulating layer 40. The fifth insulating layer 50 may be disposed on the fourth insulating layer 40 to cover the first connecting electrode CN1. The second connecting electrode CN2 may be disposed on the fifth insulating layer 50. The sixth insulating layer 60 may be disposed on the fifth insulating layer 50 to cover the second connecting electrode CN2. According to an embodiment, at least one selected from the fifth insulating layer 50 or the sixth insulating layer 60 may include an organic layer and may cover a step difference between underlying components to provide a flat top surface thereon.

The first connecting electrode CN1 may be electrically connected to the semiconductor pattern SM through a contact hole defined or formed through the second to fourth insulating layers 20 to 40. The second connecting electrode CN2 may be electrically connected to the first connecting electrode CN1 through a contact hole formed through the fifth insulating layer 50.

Each of the first connecting electrode CN1 and the second connecting electrode CN2 may include a conductive material. Each of the first connecting electrode CN1 and the second connecting electrode CN2 may include gold, silver, copper, aluminum, platinum, molybdenum, titanium, or an alloy thereof. At least one selected from the first connecting electrode CN1 or the second connecting electrode CN2 may include conductive layers in a multi-layer structure. In an embodiment, for example, at least one of the first connecting electrode CN1 and the second connecting electrode CN2 may have a three-layer structure of titanium/aluminum/titanium. However, an embodiment is not limited thereto.

According to an embodiment of the circuit element layer CL, at least one selected from the first connecting electrode CN1 or the second connecting electrode CN2 may be omitted. Alternatively, according to an embodiment of the circuit element layer CL, an additional connecting electrode to connect the transistor TR and the light emitting element OLED may be further disposed. The electrical connection manner between the light emitting element OLED and the transistor TR may be variously changed depending on the number of insulating layers interposed between the light emitting element OLED and the transistor TR. However, the present disclosure is not limited to any one embodiment.

The light emitting element layer LEL may include the light emitting element OLED and a pixel defining layer PDL. The light emitting element OLED and the pixel defining layer PDL may be disposed on the sixth insulating layer 60. The light emitting element OLED may include a first electrode AE, an emission layer EML, and a second electrode CE.

The first electrode AE may be electrically connected to the second connecting electrode CN2 through a contact hole defined or formed through the sixth insulating layer 60. The first electrode AE may be electrically connected to the transistor TR through the first and second connecting electrodes CN1 and CN2.

The pixel defining layer PDL may define a pixel opening PX-OP which exposes at least a portion of the first electrode AE. A region, which is exposed from the pixel defining layer PDL, of the first electrode AE may correspond to an emission region. The pixel defining layer PDL may include an inorganic layer, an organic layer, or a composite material layer. According to an embodiment, the pixel defining layer PDL may include a black pigment or a black dye.

The emission layer EML may be disposed on the first electrode AE. The emission layer EML may provide or emit a light having a specific color. The emission layer EML may be disposed corresponding to the pixel opening PX-OP defined in the pixel defining layer PDL. A plurality of light emitting elements OLED and a plurality of pixel openings PX-OP may be provided, and emission layers EML of the light emitting elements OLED may be respectively disposed corresponding to the pixel openings PX-OP and may be provided in the form of patterns spaced apart from each other. However, the present disclosure is not limited thereto. The emission layers EML of the light emitting elements OLED may be formed as a common layer integrally formed.

The second electrode CE may be disposed on the emission layer EML and the pixel defining layer PDL. The second electrode CE may be provided in the form of a common electrode which is commonly disposed for pixels PX (see FIG. 6).

In an embodiment, the light emitting element OLED may include at least one selected from a hole control region, which is interposed between the first electrode AE and the emission layer EML, or an electron control region, which is interposed between the emission layer EML and the second electrode CE. The hole control region may include at least one selected from a hole generation layer, a hole transport layer, or an electron blocking layer, and the electron control region may include at least one of an electron generation layer, an electron transport layer, or a hole blocking layer.

The encapsulating layer ECL may be disposed on the light emitting element layer LEL. The encapsulating layer ECL may be disposed on the light emitting element OLED and the pixel defining layer PDL to seal the light emitting element OLED. The encapsulating layer ECL may include at least one of an inorganic film or an organic film. According to an embodiment, the encapsulating layer ECL may include a first inorganic film EN1, a second inorganic film EN3, and an organic film EN2 interposed between the first and second inorganic films EN1 and EN3. However, the structure of the encapsulating layer ECL is not limited thereto as long as the encapsulating layer ECL seals the light emitting element OLED.

The first inorganic film EN1 may be disposed on the second electrode CE, and the organic film EN2 and the second inorganic film EN3 may be sequentially disposed on the first inorganic film EN1 in a thickness direction of a display panel DP. The first and second inorganic films EN1 and EN3 may protect the light emitting element OLED from moisture or oxygen introduced from the outside. In an embodiment, for example, each of the first and second inorganic films EN1 and EN3 may include at least one selected from silicon nitride, silicon oxynitride, silicon oxide, titanium oxide, or aluminum oxide. However, the materials for the first and second inorganic films EN1 and EN3 are not limited to the above examples. The organic film EN2 may prevent foreign substances from being introduced into the light emitting element OLED to cover a step difference of components disposed under the organic film EN2. In an embodiment, for example, the organic film EN2 may include an acrylic-based organic material. However, the material of the organic film EN2 is not limited to the above example.

The input sensing unit ISP may be disposed on the display panel DP. The input sensing unit ISP may include the base layer IL1, the first sensing insulating layer IL2, a first sensing conductive layer CL1, and a second sensing conductive layer CL2. The input sensing unit ISP may include a second sensing insulating layer IL3 (see FIG. 5), as illustrated in FIG. 5. Any repetitive detailed description of the same or like components as those described above will be omitted to avoid redundancy.

The base layer IL1 may make contact with the uppermost layer of the encapsulating layer ECL. In an embodiment, for example, the base layer IL1 may make contact with the second inorganic film EN3 of the encapsulating layer ECL. The base layer IL1 of the input sensing unit ISP may be directly formed on the base surface provided by the encapsulating layer ECL. However, the present disclosure is not limited thereto. According to an embodiment, the base layer IL1 may be omitted. In this case, the first sensing conductive layer CL1 of the input sensing unit ISP may make contact with the encapsulating layer ECL.

The first sensing conductive layer CL1 may be disposed on the base layer IL1, and the second sensing conductive layer CL2 may be disposed on the first sensing insulating layer IL2. The first sensing conductive layer CL1 and the second sensing conductive layer CL2 may constitute or collectively define a sensing electrode TE. The sensing electrode TE may correspond to one of the first and second sensing electrodes TEX and TEY described above (see FIG. 7). In an embodiment, for example, the first sensing conductive layer CL1 may include a connecting pattern BP of the sensing electrode TE, and the second sensing conductive layer CL2 may include a sensing pattern SP of the sensing electrode TE. However, the present disclosure is not limited thereto. The first sensing conductive layer CL1 may include the sensing pattern SP, and the second sensing conductive layer CL2 may include the connecting pattern BP.

The connecting pattern BP may correspond to the first connecting pattern BP1 (see FIG. 7) or the second connecting pattern BP2 which are described above (see FIG. 7), and the sensing pattern SP may correspond to the first sensing pattern SP1 (see FIG. 7) or the second sensing pattern SP2 described above (see FIG. 7). The connecting pattern BP may be disposed in (or directly on) a layer different from a layer for (or defining) the sensing pattern SP and may be connected through a contact hole defined or formed through the first sensing insulating layer IL2. However, the present disclosure is not limited thereto. In an embodiment, for example, the connecting pattern BP and the sensing pattern SP may be disposed in (or directly on) a same layer as each other and may be formed integrally with each other as a single unitary indivisible part.

The sensing electrode TE may have a mesh-shaped pattern and may be disposed corresponding to a region in which the pixel defining layer PDL is disposed. However, the present disclosure is not limited thereto. In an embodiment, for example, the sensing electrode TE may also be provided as a single-shaped pattern overlapping the light emitting element OLED. In such an embodiment, the sensing electrode TE may include a transparent conductive material.

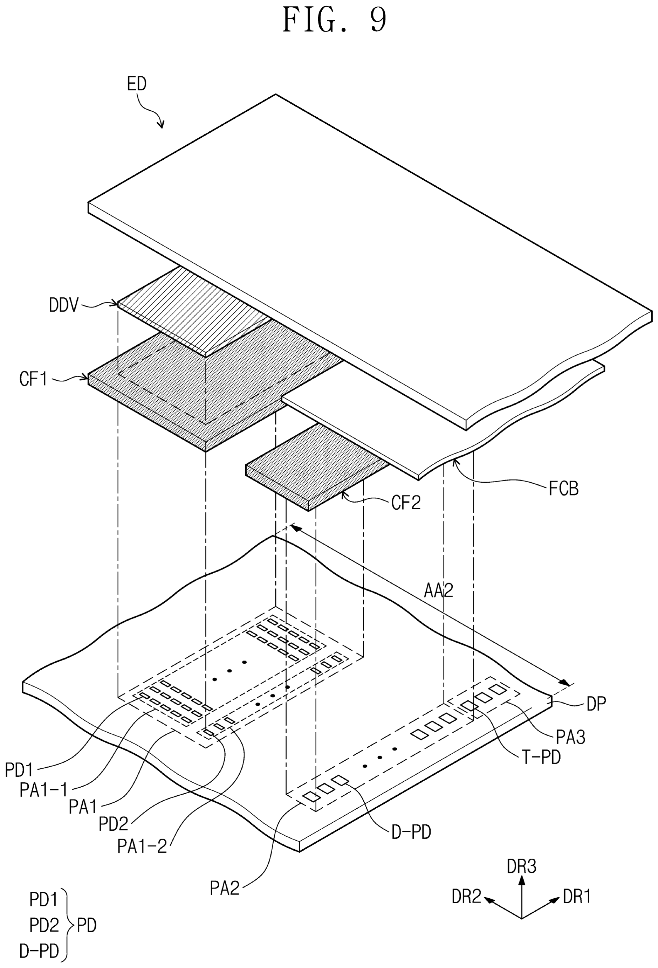

FIG. 9 is a perspective view of an electronic device according to an embodiment of the present disclosure, and FIG. 9 briefly illustrates some components, which are disposed corresponding to the second base region AA2, of the electronic device ED.

The second base region AA2 in FIG. 9 corresponds to a portion of the non-display region NDA (see FIG. 6). As illustrated in FIG. 9, a region, which is bonded to the data driver DDV, of the non-display region NDA or the second base region AA2 is defined as a first pad region PA1, and a region to be bonded to the flexible circuit board FCB is defined as a second pad region PA2. The second pad region PA2 may be referred to as a display pad region.

The data driver DDV may be bonded to the first pad region PA1 through a first adhesive layer CF1, and the flexible circuit board FCB may be bonded to the second pad region PA2 through a second adhesive layer CF2. Each of the first adhesive layer CF1 and the second adhesive layer CF2 may include a synthetic resin having adhesiveness. Each of the first adhesive layer CF1 and the second adhesive layer CF2 may be an anisotropic conductive film. In an embodiment, for example, each of the first adhesive layer CF1 and the second adhesive layer CF2 may include an adhesive resin and conductive particles dispersed in the adhesive resin.

The first adhesive layer CF1 may overlap the first pad region PA1. The first adhesive layer CF1 may overlap the data driver DDV. The second adhesive layer CF2 may overlap the second pad region PA2. The second adhesive layer CF2 may overlap the flexible circuit board FCB.

The display panel DP may include a plurality of pads PD. The plurality of pads PD may include first signal pads PD1, second signal pads PD2, and display pads D-PD. The first signal pads PD1, the second signal pads PD2, and the display pads D-PD may be pads disposed in a signal transmission path.

The first signal pads PD1 may be disposed corresponding to output pads of the data driver DDV and may be input pads which receive signals from the data driver DDV. The second signal pads PD2 may be disposed corresponding to input pads of the data driver DDV and may be output pads which output signals to the data driver DDV. The display pads D-PD may be panel input pads which receive signals from the flexible circuit board FCB.

Each of the first signal pads PD1 may be electrically connected to the pixels PX of the display panel DP (see FIG. 6) through signal lines and may transmit and receive signals to and from the pixels PX (see FIG. 6). Each of the second signal pads PD2 may be electrically connected to a relevant one of the display pads D-PD among the display pads D-PD through a signal line, and the display pads D-PD and the second signal pads PD2, which are electrically connected to each other, may transmit and receive signals.

The first pad region PA1 may include a first sub-pad region PA1-1 and a second sub-pad region PA1-2. The first sub-pad region PA1-1 may be defined as a region in which the first signal pads PD1 are disposed. The second sub-pad region PA1-2 may be defined as a region in which the second signal pads PD2 are disposed.

The first signal pads PD1 may be arranged in the first sub-pad region PA1-1, in the first direction DR1 and the second direction DR2. The first signal pads PD1, which are arranged in the first direction DR1, among the first signal pads PD1 may be defined as pad rows. FIG. 9 illustrates an embodiment where five pad rows are arranged in the second direction DR2. However, the arrangement of the first signal pads PD1 is not limited thereto.

The second signal pads PD2 may be arranged in the second sub-pad region PA1-2 in the first direction DR1. In an embodiment, as shown in FIG. 9, the second signal pads PD2 may be arranged in a single pad row. However, the arrangement of the second signal pads PD2 is not limited thereto.

According to an embodiment of the present disclosure, the display panel DP may include test pads T-PD. The test pads T-PD are pads to perform a driving test of the display panel DP before attaching circuit components (for example, a data driver, a flexible circuit board) to drive the display panel DP. The test pads T-PD are connected to an internal circuit of the display panel DP such that, when a driving signal is applied to the test pads T-PD, the display panel DP is driven.

The test pads T-PD may be disposed to be spaced apart from the second pad region PA2, in which the display pads D-PD are disposed, in the first direction DR1. A region in which the test pads T-PD are disposed may be defined as a third pad region PA3. The third pad region PA3 may be referred to as a test pad region. However, the test pads T-PD shown in FIG. 9 is merely an example, and a position at which the test pads T-PD are disposed is not limited thereto.

Although not illustrated, the electronic device ED according to an embodiment may include a conductive tape. The conductive tape may be disposed on the data driver DDV and the flexible circuit board FCB, to effectively prevent noise from being caused by electromagnetic waves or static electricity.

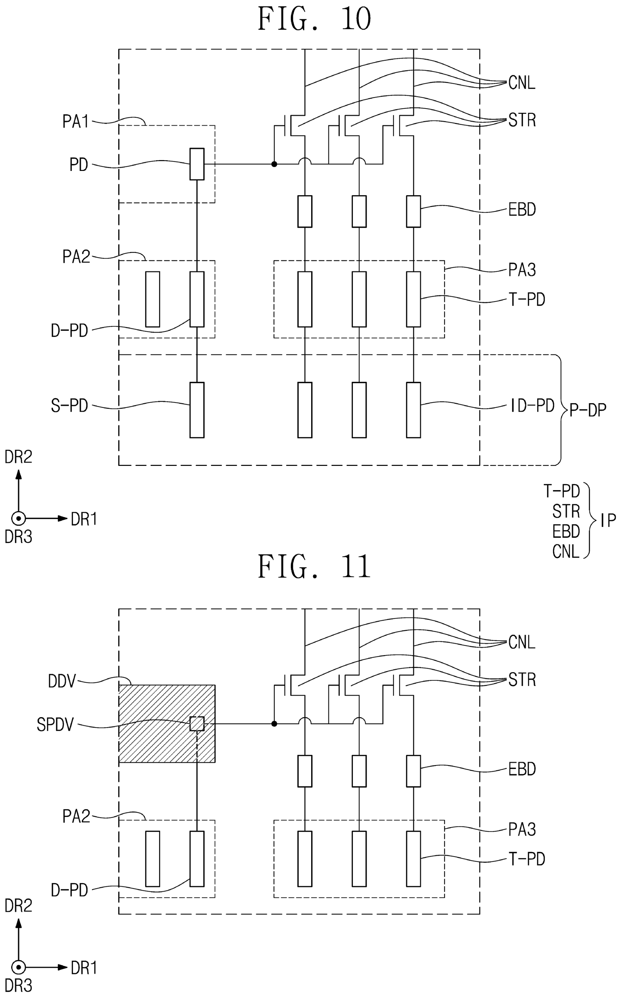

FIGS. 10 and 11 are views to explain driving of the test pads according to an embodiment of the present disclosure. Particularly, FIGS. 10 and 11 are enlarged views illustrating a portion of the second base region AA2 (see FIG. 6). FIG. 10 illustrates a test driving unit P-DP. The test driving unit P-DP may be a component to apply a test signal to the test pads T-PD to test for defects of the pixels PX (see FIG. 6) before forming the display panel DP (see FIG. 6) according to an embodiment of the present disclosure. Hereinafter, any repetitive detailed descriptions of the same or like components as those described above will be omitted to avoid redundancy.

Referring to FIG. 10, in an embodiment, the test driving unit P-DP may include test driving pads ID-PD and a switching pad S-PD. The number of the test driving pads ID-PD may be the same as the number of the test pads T-PD.

The test driving pads ID-PD may be electrically connected to the test pads T-PD, respectively. In an embodiment, for example, the test driving pads ID-PD may apply test signals to the test pads T-PD. The test signals may be applied to the pixels PX (see FIG. 6) through electrostatic discharge protecting diodes EBD and switching transistors STR.

According to an embodiment of the present disclosure, the switching pad S-PD may be connected to at least one of the display pads D-PD. The display pad D-PD connected may be electrically connected to the pad PD disposed in the first pad region PA1. The pad PD in the first pad region PA1 may be electrically connected to each of the switching transistors STR. In an embodiment, for example, the pad PD in the first pad region PA1 may be electrically connected to gates of the switching transistors STR. In other words, the switching transistors STR may be electrically connected to the switching pad S-PD.

The switching pad S-PD may control gate voltages of the switching transistors STR. According to an embodiment, the switching pad S-PD may reduce the gate voltages of the switching transistors STR to turn on the switching transistors STR.

FIG. 11 is a view illustrating a partial region of the display panel DP (see FIG. 6) in which the test driving unit P-DP of FIG. 10 is removed and the data driver DDV is bonded to the first pad region PA1. Referring to FIG. 11, the switching transistors STR according to an embodiment of the present disclosure may be electrically connected to the data driver DDV. The data driver DDV may include a switching circuit SPDV. The switching transistors STR may be electrically connected to the switching circuit SPDV of the data driver DDV.

The switching circuit SPDV may control the gate voltages of the switching transistors STR. According to an embodiment, the switching circuit SPDV may increase the gate voltages of the switching transistors STR to turn off the switching transistors STR. Alternatively, the switching circuit SPDV may maintain a high voltage level to turn off the switching transistors STR. Alternatively, the switching transistors STR may be directly connected to a dummy pad, instead of the switching circuit SPDV such that the switching transistors STR are turned off. This allows an improved control of the off state of the switching transistors STR to prevent potential difference corrosion.

The display pad D-PD may be a floating electrode. According to an embodiment, although the display pad D-PD is illustrated as being electrically connected to the switching circuit SPDV, the present disclosure is not limited thereto. In an embodiment, for example, the display pad D-PD may not be electrically connected to the switching circuit SPDV.

Referring back to FIG. 10, the test driving pads ID-PD may apply test signals to the test pads T-PD. A state in which the test signals are applied to the test pads T-PD may be referred to as a first mode. In other words, in the first mode, the test signals may be applied to the pixels PX through the test pads T-PD. In the first mode, the switching pad S-PD may lower the gate voltages of the switching transistors STR to turn the switching transistors STR on. As a result, the test signals applied by the test driving pads ID-PD may be applied to the pixels PX (see FIG. 6) through the connecting lines CNL. In this way, the control of the states of the switching transistors STR is improved.

Referring to FIGS. 6 and 11 together, after the test driving unit P-DP is removed, the signals (for example, the control signal, the data signal, and the power voltage) may be applied to the pixels PX through the display pads D-PD, the first and second control lines CSL1 and CSL2, the data lines DL1 to DLn, and the power line PL. A state in which the first and second control lines CSL1 and CSL2, the data lines DL1 to DLn, and the power line PL apply signals (the control signal, the data signal, and the power voltage) to the pixels PX may be referred to as a second mode. In the second mode, the switching circuit SPDV may increase the gate voltages of the switching transistors STR to turn off the switching transistors STR. When the switching transistors STR are turned off, a current does not flow to the electrostatic discharge protecting diodes EBD and the test pads T-PD connected to the connecting lines CNL, and a potential difference may not be made between the electrostatic discharge protecting diodes EBD and the test pads T-PD. Accordingly, corrosion resulting from the potential difference at the electrostatic discharge protecting diodes EBD and the test pads T-PD may be effectively prevented, and a reliable display device DD (see FIG. 4) may be provided.

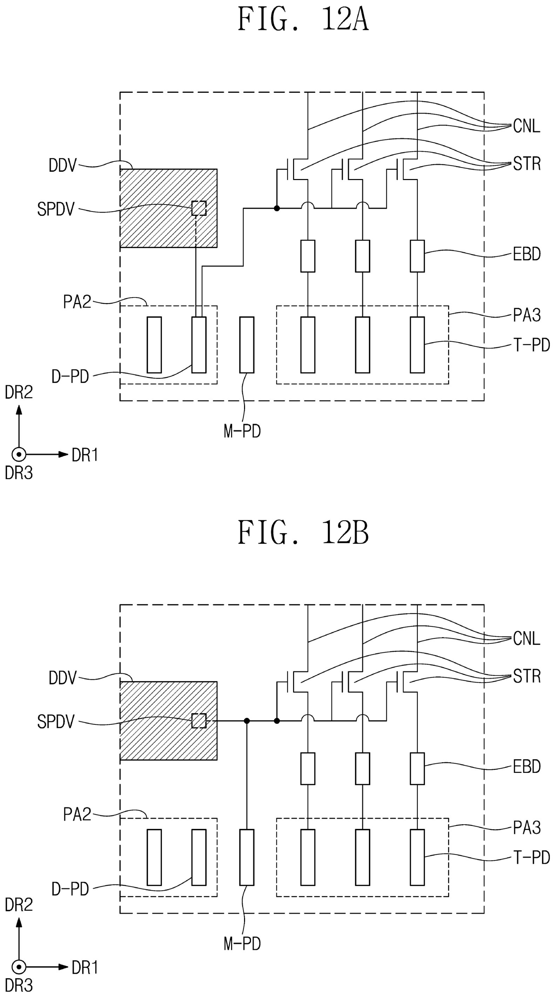

FIGS. 12A and 12B are enlarged views of a portion of the display panel according to an embodiment of the present disclosure. Particularly, FIGS. 12A and 12B are views to explain the switching transistors STR in the second mode of FIG. 11.

Referring to FIG. 12A, the switching transistors STR according to an embodiment of the present disclosure may be electrically connected to the switching circuit SPDV through a display pad D-PD among the display pads D-PD. In such an embodiment, the switching circuit SPDV may increase the gate voltages of the switching transistors STR to turn off the switching transistors STR.

Referring to FIGS. 12A and 12B together, the display panel DP (see FIG. 6) according to an embodiment of the present disclosure may include a dummy pad M-PD. The dummy pad M-PD may be interposed between the display pads D-PD and the test pads T-PD. As illustrated in FIG. 12B, the switching transistors STR according to an embodiment of the present disclosure may be electrically connected to the switching circuit SPDV through the dummy pad M-PD.

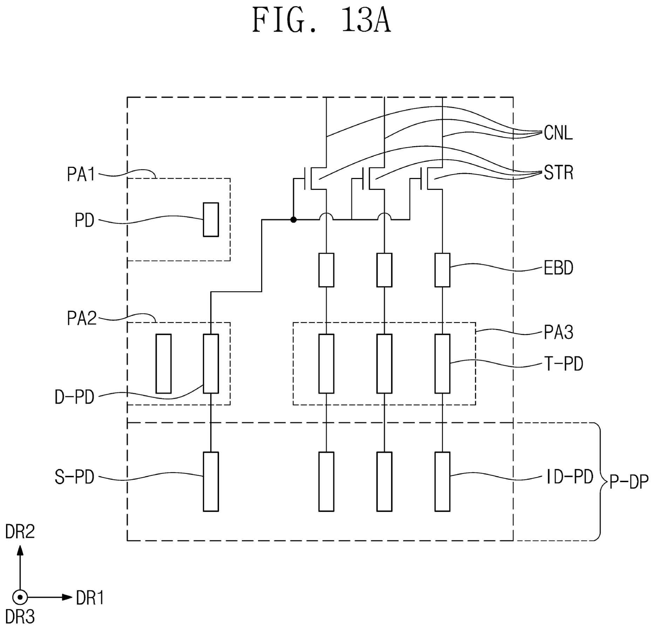

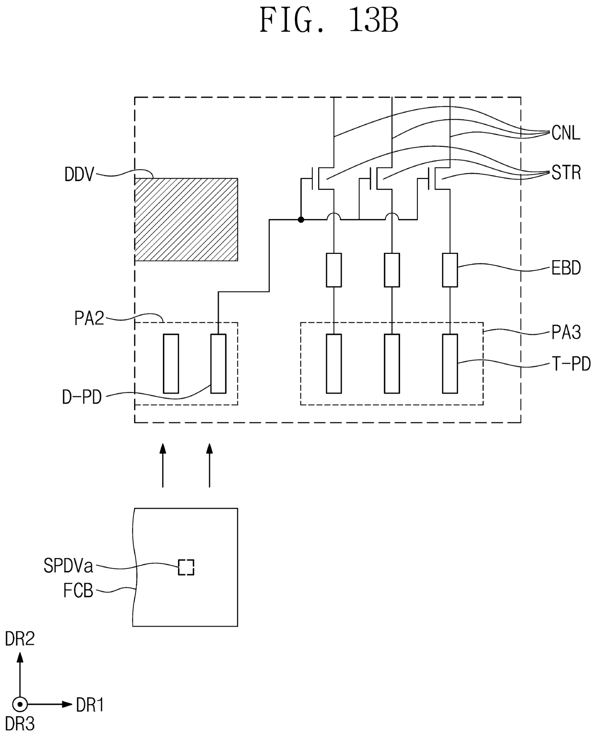

FIGS. 13A and 13B are views to explain the driving of test pads according to an embodiment of the present disclosure.

The test driving unit P-DP illustrated in FIG. 13A is similar to that illustrated in FIG. 10. The test driving unit P-DP may be a component that applies the test signals to the test pads T-PD, to test whether defects exist in the pixels PX (see FIG. 6) before forming the display panel DP (see FIG. 6) according to an embodiment of the present disclosure.

The switching pad S-PD may be connected to at least one of the display pads D-PD. The switching pad S-PD may be electrically connected to each of the switching transistors STR through the connected display pad D-PD.

The switching pad S-PD may control the gate voltages of the switching transistors STR. According to an embodiment, the switching pad S-PD may lower the gate voltages of the switching transistors STR to turn on the switching transistors STR.

Referring to FIGS. 6 and 13B together, after the test driving unit P-DP is removed, the first and second control lines CSL1 and CSL2, the data lines DL1 to DLn, and the power line PL may apply the signals (for example, the control signal, the data signal, and the power voltage) to the pixels PX through the display pads D-PD..

As illustrated in FIG. 13B, the flexible circuit board FCB may be bonded to the second pad region PA2. The flexible circuit board FCB may include a switching circuit SPDVa. The switching transistors STR according to an embodiment of the present disclosure may be electrically connected to the switching circuit SPDVa of the flexible circuit board FCB.

The switching circuit SPDVa may increase the gate voltages of the switching transistors STR to turn off the switching transistors STR. When the switching transistors STR are turned off, a current does not flow to the electrostatic discharge protecting diodes EBD and the test pads T-PD connected to the connecting lines CNL, and a potential difference may not be made between the electrostatic discharge protecting diodes EBD and the test pads T-PD.

According to an embodiment of the present disclosure, the switching transistor may be interposed between the test pad to test the display panel and the signal line. The switching transistors may be turned on or off by controlling the gate voltages of the switching transistors. When the switching transistors are turned off, the current does not flow through the test pads, and the potential difference may not be made at the test pads. Accordingly, corrosion resulting from the potential difference is prevented at the test pads, thereby providing the display device having the reliability.

According to an embodiment, the test unit is disposed adjacent to the plurality of display pads.

According to an embodiment, a display device is provided comprising a display panel including a display region including a plurality of pixels disposed in the display region and a non-display region surrounding the display region; a plurality of display pads disposed in a pad region of the non-display region; a plurality of signal lines connected to the plurality of pixels; and a test unit disposed to be adjacent to the plurality of display pads, wherein the test unit includes a plurality of test pads spaced apart from the plurality of display pads in a first direction; a plurality of connecting lines which connects the plurality of test pads to the plurality of signal lines, respectively; and a plurality of switching transistors which is turned on in a first mode of the display panel, and turned off in a second mode different from the first mode of the display panel.

According to an embodiment, the display device further comprises a data driver including a switching circuit electrically connected to the switching transistors to control gate voltages of the switching transistors.

According to an embodiment, at least one of the plurality of display pads is electrically connected to the plurality of switching transistors and the switching circuit.

According to an embodiment, the display device further comprises a circuit board electrically connected to the display panel through the plurality of display pads, wherein the plurality of switching transistors is electrically connected to the circuit board.

According to an embodiment, the circuit board includes a switching circuit which controls gate voltages of the plurality of switching transistors. The invention should not be construed as being limited to the embodiments set forth herein. Rather, these embodiments are provided so that this disclosure will be thorough and complete and will fully convey the concept of the invention to those skilled in the art. While the invention has been particularly shown and described with reference to embodiments thereof, it will be understood by those of ordinary skill in the art that various changes in form and details may be made therein without departing from the invention as defined by the following claims.

## Claims

1. A display device (DD) comprising:
a display panel (DP) including a display region (DA) including a plurality of pixels (PX) disposed in the display region (DA) and a non-display region (NDA) surrounding the display region (DA);
a plurality of display pads (D-DP) disposed in a pad region (PA1) of the non-display region (NDA);
a plurality of signal lines (SL1-SLm, DL1-DLn, EL1-ELm, CSL1, CSL2, PL) connected to the plurality of pixels (PX);
a data driver (DDV) electrically connected to the plurality of signal lines (SL1-SLm, DL1-DLn, EL1-ELm, CSL1, CSL2, PL); and
a test unit (IP) disposed to be adjacent to the data driver (DDV),
wherein the test unit (IP) includes:
a plurality of test pads (T-PD) spaced apart from the plurality of display pads (D-DP) in a first direction (DR1);
a plurality of connecting lines (CNL) extending in a second direction (DR2) crossing the first direction (DR1), wherein the plurality of connecting lines (CNL) connects the plurality of test pads (T-PD) to the plurality of signal lines (SL1-SLm, DL1-DLn, EL1-ELm, CSL1, CSL2, PL), and
a plurality of switching transistors (STR) electrically connected to the plurality of test pads (T-PD), respectively, and to the plurality of signal lines (SL1-SLm, DL1-DLn, EL1-ELm, CSL1, CSL2, PL), respectively.

2. The display device (DD) of claim 1, wherein the plurality of switching transistors (STR) is electrically connected to the data driver (DDV), and/or wherein the plurality of switching transistors (STR) are turned on in a first mode of the display panel (DP), and turned off in a second mode different from the first mode of the display panel (DP).

3. The display device (DD) of claim 1 or claim 2, wherein the data driver (DDV) includes:
a switching circuit (SPDV) which controls gate voltages of the plurality of switching transistors (STR).

4. The display device (DD) of claim 3, wherein the plurality of switching transistors (STR) is turned off by the switching circuit (SPDV).

5. The display device (DD) of claim 3 or claim 4, wherein at least one of the plurality of display pads (D-DP) is electrically connected to the plurality of switching transistors (STR) and the switching circuit (SPDV).

6. The display device (DD) of one of claims 3 through 5, further comprising:
a dummy pad (M-PD) interposed between the plurality of display pads (D-DP) and the plurality of test pads (T-PD),
wherein the dummy pad (M-PD) is electrically connected to the plurality of switching transistors (STR) and the switching circuit (SPDV).

7. The display device (DD) of one of the preceding claims, further comprising:
a circuit board (FCB) electrically connected to the display panel (DP) through the plurality of display pads (D-DP),
wherein the plurality of switching transistors (STR) are electrically connected to the circuit board (FCB).

8. The display device (DD) of one of the preceding claims, wherein the circuit (FCB) board includes:
a switching circuit (SPDV) which controls gate voltages of the plurality of switching transistors (STR).

9. The display device (DD) of one of claims 3 through 8, wherein the plurality of switching transistors (STR) are turned on or off by the switching circuit (SPDV) included in the circuit board (FCB).

10. The display device (DD) of one of the preceding claims, wherein at least one of the plurality of display pads (D-DP) is electrically connected to the plurality of switching transistors (STR) and the switching circuit (SPDV).

11. The display device (DD) one of the preceding claims, further comprising:
a plurality of pads (PD) overlapping the data driver (DDV).

12. The display device (DD) of one of the preceding claims, wherein the test unit (IP) further includes:
an electrostatic discharge protecting diode interposed between the plurality of switching transistor (STR) and plurality of test pads (T-PD), in the second direction (DR2).

13. The display device (DD) of one of the preceding claims, wherein the plurality of switching transistor is interposed between the plurality of test pads (T-PD) and the plurality of signal lines (SL1-SLm, DL1-DLn, EL1-ELm, CSL1, CSL2, PL) in the second direction (DR2).

14. An electronic device (ED) comprising:
a display device (DD) which displays an image; and
a processor (PC) which provides image data to the display device (DD),
wherein the display device (DD) includes:
a display panel (DP) including a display region (DA) with a plurality of pixels (PX) and a non-display region (NDA) surrounding the display region (DA);
a plurality of display pads (D-DP) disposed in a pad region (PA1) of the non-display region (NDA);
a plurality of signal lines (SL1-SLm, DL1-DLn, EL1-ELm, CSL1, CSL2, PL) connected to the plurality of pixels (PX);
a data driver (DDV) electrically connected to the plurality of signal lines (SL1-SLm, DL1-DLn, EL1-ELm, CSL1, CSL2, PL); and
a test unit (IP) disposed to be adjacent to the data driver (DDV),
wherein the test unit (IP) includes:
a plurality of test pads (T-PD) spaced apart from the plurality of display pads (D-DP) in a first direction (DR1);
a plurality of connecting lines (CNL) extending in a second direction (DR2) crossing the first direction (DR1), wherein the plurality of connection lines connects the plurality of test pads (T-PD) to the plurality of signal lines (SL1-SLm, DL1-DLn, EL1-ELm, CSL1, CSL2, PL); and
a plurality of switching transistors (STR) electrically connected to the plurality of test pads (T-PD), respectively, and to the plurality of signal lines (SL1-SLm, DL1-DLn, EL1-ELm, CSL1, CSL2, PL), respectively.

15. The electronic device of claim 14, further comprising:
a circuit board (FCB) electrically connected to the display panel (DP) through the plurality of display pads (D-DP),
wherein the plurality of switching transistors (STR) is electrically connected to the circuit board (FCB).
